Europäisches Patentamt

European Patent Office

Office européen des brevets

(11) Publication number: **0 069 214 B1**

# EUROPEAN PATENT SPECIFICATION

(45) Date of publication of patent specification: **27.02.91**   (51) Int. Cl.⁵: **H03J 7/18, H03G 3/34**

(21) Application number: **82103930.2**

(22) Date of filing: **06.05.82**

(54) Circuit for measuring the reception quality of an FM receiver.

(30) Priority: **03.07.81 DE 3126224**

(43) Date of publication of application:
**12.01.83 Bulletin 83/02**

(45) Publication of the grant of the patent:
**27.02.91 Bulletin 91/09**

(84) Designated Contracting States:
**AT FR GB IT**

(56) References cited:
**DE-A- 1 591 144         DE-A- 2 345 649**
**DE-A- 2 534 310         DE-A- 2 840 533**
**US-A- 3 448 385         US-A- 4 044 309**

**ELEKTOR, Band 2, Nr.7-8, Juli-August 1976,**
**Elektor Publishers Ltd., Canterbury (GB),**
**"Squelch", Seite 745, Nr. 64**

(73) Proprietor: **Blaupunkt-Werke GmbH**
**Robert-Bosch-Strasse 200**
**D-3200 Hildesheim(DE)**

(72) Inventor: **Wiedemann, Kurt**
**Bismarckplatz 5**
**D-3200 Hildesheim(DE)**
Inventor: **Schindler, Hans-Joachim**
**Postweg 16**
**D-3208 Giesen OT Hasede(DE)**

(74) Representative: **Eilers, Norbert, Dipl.-Phys.**
**Blaupunkt-Werke GmbH Robert-**
**Bosch-Strasse 200**
**D-3200 Hildesheim(DE)**

## Beschreibung

### Stand der Technik

Die Erfindung geht aus von einer Schaltungsanordnung zur Ermittlung der Empfangsqualität für einen FM-Empfänger nach der Gattung der Ansprüche 1 oder 2. Bei Sendersuchlaufanordnungen oder Antennen-Diversity-Empfang ist es erforderlich, den jeweils eingestellten Sender/Antenne auf Empfangsqualität zu prüfen. Als Meßgröße für die Empfangsqualität wird bei den bekannten Schaltungsanordnungen der HF-Eingangspegel des Empfängers herangezogen. Dabei ist es völlig belanglos, ob es sich um einen üblichen Sendersuchlauf oder um einen Sendersuchlauf mit abgespeicherten Senderfrequenzen handelt, bei dem der HF-Eingangspegel des empfangenen Senders mit zuvor gespeicherten HF-Pegelwerten anderer Senderstationen verglichen wird.

Es ist eine Empfangseinrichtung mit einer automatischen Umschalteinrichtung gemäß dem Oberbegriff des Anspruchs 1 oder 2 bekannt (DE-A-1 591 144), durch die immer derjenige der auf Sender gleichen Modulationsinhaltes abgestimmten Empfängerzüge durchgeschaltet wird, der die bessere Empfangsqualität bietet. Dabei wird die Umschalteinrichtung über eine die Hochfrequenzeingangspegel vergleichende Pegelvergleichseinrichtung sowie über eine Modulationsvergleichseinrichtung gesteuert.

Bei diesen bekannten Schaltungsanordnungen wird davon ausgegangen, daß die Empfangsqualität der Feldstärke und damit dem HF-Pegel proportional ist. Dieses trifft aber nur dann zu, wenn ideale Empfangsverhältnisse vorliegen. Beispielsweise macht sich beim Autoradio der Mehrwegeempfang oder der während der Fahrt auftretende, durch Reflexionen hervorgerufene, sogenannte Lattenzauneffekt sehr störend bemerkbar. Die Qualität eines solchen Empfangssignals ist nicht mehr an dem HF-Eingangspegel meßbar, insbesondere, wenn dieser so hoch liegt, daß der Begrenzer im UKW-Teil wirksam ist. Es ist durchaus möglich, daß ein Signal mit hohem HF-Eingangspegel völlig empfangsunwürdig ist, während ein Signal mit einem geringen HF-Eingangspegel durchaus empfangswürdig sein kann. Insbesondere bei Autoradios ist daher eine befriedigende Beurteilung der Qualität eines empfangenen Signals aufgrund des HF-Eingangspegels kaum möglich.

Aus der Druckschrift DE-A-2 534 310 ist es bekannt, den Rauschpegel statt der HF-Signalstärke zu benutzen, um einen Empfänger für Stereosendungen immer dann auf Mono-Empfang umzuschalten, wenn der empfangene Sender aufgrund geringer Empfangsfeldstärke eine Wiedergabe mit hohen Rauschanteilen bewirkt. Hierbei wird lediglich die Tatsache genutzt, daß sich der Rauschpegel am Demodulatorausgang umgekehrt proportional zur Empfangsfeldstärke verhält. Eine derartige Schaltungsanordnung vermag jedoch nicht zu unterscheiden, ob es sich um Störsignale handelt, die beim Empfang eines NF-modulierten Trägers oder bei fehlendem Träger auftreten.

Der Erfindung liegt die Aufgabe zugrunde, einen für Stereoempfang in Kraftfahrzeugen eingerichteten UKW-Empfänger mit einer Steuerschaltung zu schaffen, die beim Auftreten von Mehrwegeempfang den Empfangsteil derart steuert, daß er ein möglichst ungestörtes Sendersignal gleichen Modulationsinhaltes empfängt.

### Vorteile der Erfindung

Die erfindungsgemäße Schaltungsanordnung zur Ermittlung der Empfangsqualität mit den kennzeichnenden Merkmalen der Ansprüche 1 oder 2 hat den Vorteil, daß völlig unabhängig von der HF-Eingangsspannung, insbesondere durch Mehrwegeempfang bedingte Signalstörungen, sehr schnell und sicher erkannt und ausgewertet werden können und daß während einer Modulationspause keine Fehlmessung bei Mehrwegeempfang erfolgen kann.

Durch die in den Unteransprüchen aufgeführten Maßnahmen sind vorteilhafte Ausgestaltungen der Schaltungsanordnung möglich. Durch eine Bemessung des selektiven Filters nach einem der Ansprüche 3 oder 4 wird eine hohe Selektion gegenüber weiteren, oberhalb des Multiplexsignals angeordneten Hilfsträgern, wie sie beispielsweise beim Verkehrsfunk (57 kHz) und/oder bei einer sogenannten Hintergrundmusik (67 kHz) verwendet werden, hergestellt. Eine besonders zuverlässige Erkennung auf vorhandene Modulation wird mit einer Auslegung des NF-Bandpasses nach Anspruch 5 erzielt. Durch die Ausbildung des selektiven Bandpaßfilters nach Anspruch 6 werden Störimpulse mit einer für eine Gleichrichtung vorteilhaft hohen Amplitude gewonnen. Mit einer Schaltungsanordnung nach Anspruch 8 läßt sich in einer Pegelvergleichsstufe der Wert der Störungen und damit der Wert der Empfangsqualität abfragen bzw. entnehmen. Der in der Pegelvergleichsstufe ermittelte Wert kann einem Rechner und/oder einer Steuerschaltung für einen Sendersuchlauf sowie einer Umschalteinrichtung für unterschiedliche Empfangswege, Antennen usw. zugeführt werden.

### Zeichnung

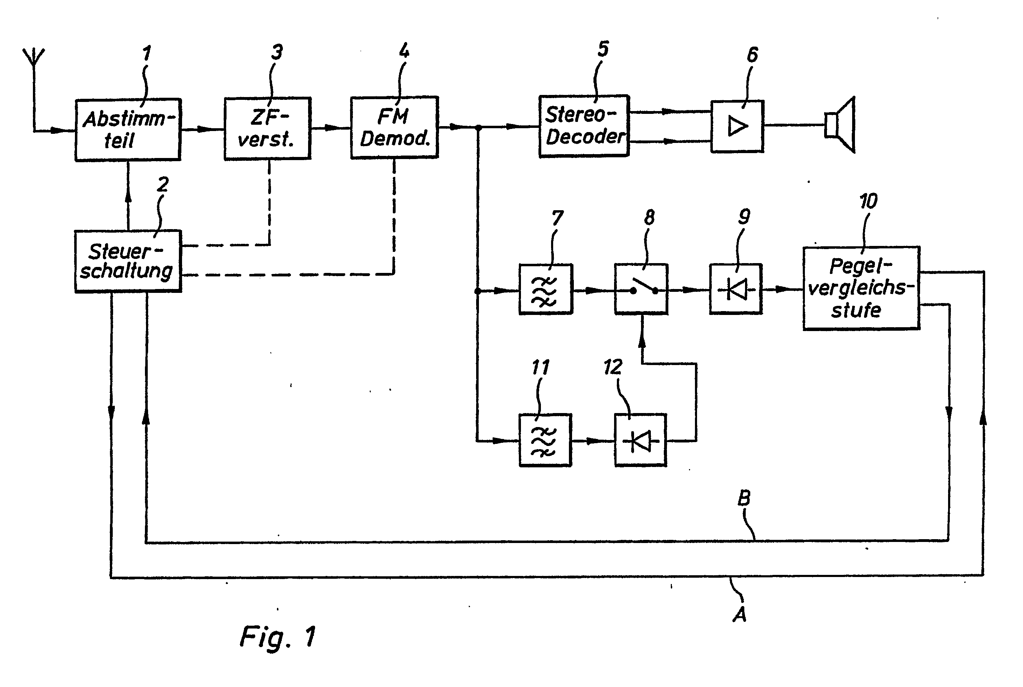

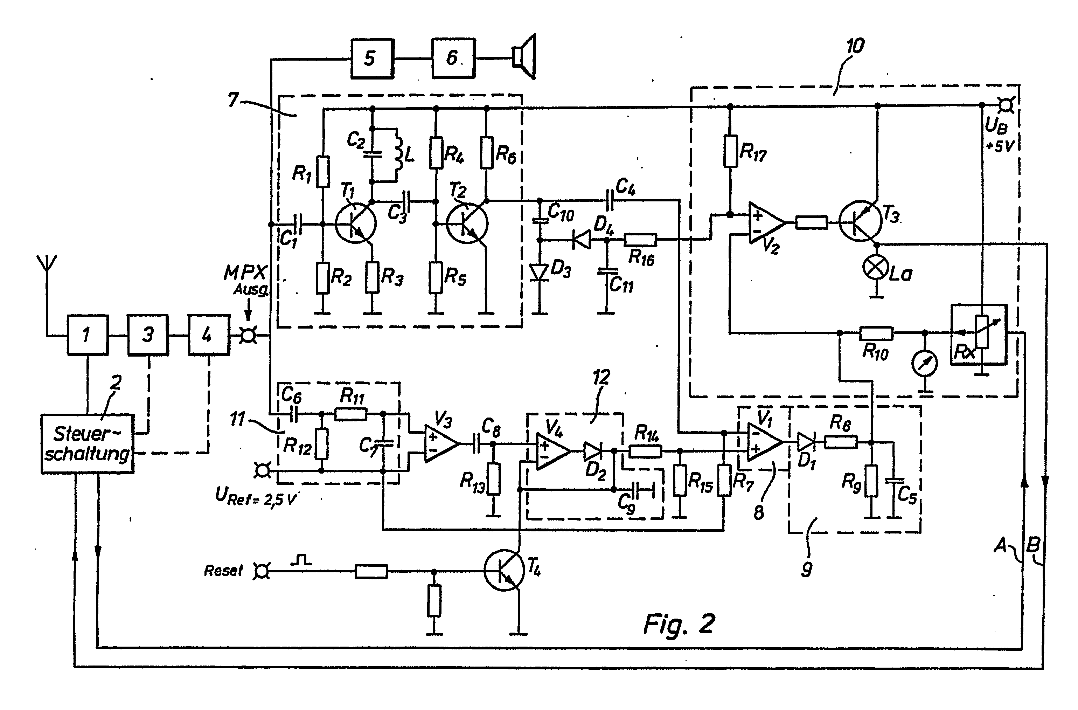

Ausfürungsbeispiele der Erfindung sind in der Zeichnung dargestellt und in der nachfolgenden Beschreibung näher erläutert. Es zeigen Figur 1 ein Blockschaltbild und Figur 2 ein weiteres Schaltbild einer Schaltungsanordnung zur Ermittlung der Empfangsqualität.

Beschreibung der Erfindung

Ein in der Figur 1 als Blockschaltbild dargestellter, für Stereoempfang eingerichteter UKW-Suchlauf-Empfänger weist ein UKW-Abstimmteil 1, eine Steuerschaltung 2 für einen Sendersuchlauf, einen ZF-Verstärker 3, einen FM-Demodulator 4, einen Stereodecoder 5 sowie einen NF-Verstärker 6 in an sich bekannter Weise auf. Der Ausgang des FM-Demodulators 4 ist über ein selektives Filter 7, dessen Durchlaßfrequenz oberhalb des Stereo-Multiplex-Signals und innerhalb der ZF-Bandbreite liegt, und über einen elektrischen Torschalter 8 mit einer ersten Gleichrichterstufe 9 verbunden, der eine Pegelvergleichsstufe 10 nachgeschaltet ist. Der Ausgang des FM-Demodulators 4 ist außerdem über einen NF-Bandpaß 11 mit einer als Spitzengleichrichter ausgebildeten zweiten Gleichrichterstufe 12 verbunden, welche mit ihrem Ausgangssignal den elektrischen Torschalter 8 betätigt. Der Ausgang und ein weiterer Eingang der Pegelvergleichsstufe 10 sind über Leitungen A und B mit der Steuerschaltung 2 für den Sendersuchlauf verbunden.

weitere Einzelheiten eines erfindungsgemäßen Ausführungsbeispiels nach Figur 1 sind aus der Figur 2 ersichtlich. Die Bezugzeichen der Figur 1 wurden beibehalten. Als selektives Filter ist ein aus Widerständen R1 bis R6, Kondensatoren C1 bis C3, Transistoren T1, T2 und einer Induktivität L aufgebauter selektiver Verstärker vorgesehen, dessen Schwingkreis C2/L bei einer Güte von etwa Q = 10 auf eine Frequenz von ca. 150 kHz abgestimmt ist. Der Ausgang des als selektives Filter 7 dienenden Verstärkers ist über einen Kondensator C4 mit dem über einen Widerstand R7 an einer positiven Referenzspannungsquelle $U_{ref}$ liegenden invertierenden Eingang eines ersten Operationsverstärkers V1 verbunden. Der Ausgang des zusätzlich als Torschaltung 8 dienenden Operationsverstärkers V1 ist mit der Anode einer Diode D1 verbunden, deren Katode über einen Widerstand R8 mit einem an Masse liegenden Ladekondensator C5, dem ein Widerstand R9 parallel geschaltet ist, verbunden. Der mit den Widerständen R8, R9 verbundene Anschluß des ein Integrationsglied bildenden Kondensators C5 ist mit dem invertierenden Eingang eines zweiten Operationsverstärkers V2 verbunden, welcher zusammen mit einem nachgeschalteten Transistor T3, einer Anzeigelampe La und einem einstellbaren Spannungsteiler Rx, dessen Abgriff über einen Widerstand R10 mit dem nicht-invertierenden Eingang des Operationsverstärkers V2 verbunden ist, die Pegelvergleichsstufe 10 bildet.

Den NF-Bandpaß 11 bildende Kondensatoren C6, C7 und Widerstände R11, R12 sind derart bemessen, daß der NF-Bandpaß 11 einen Durchlaßbereich von ca. 200 bis 5 000 Hz aufweist. Die Ausgangsklemmen des NF-Bandpasses sind mit den Eingängen eines dritten Operationsverstärkers V3 verbunden, wobei der invertierende Eingang mit der Referenzspannungsquelle $U_{ref}$ verbunden ist. Der Ausgang des dritten Operationsverstärkers V3 ist über einen Kondensator C8 mit dem über einen Widerstand R13 an Masse liegenden nicht-invertierenden Eingang eines vierten Operationsverstärkers V4 verbunden, dessen invertierender Eingang mit dem Kollektor eines mit dem Emitter an Masse liegenden Transistors T4 verbunden ist. Der Ausgang des vierten Operationsverstärkers V4 ist mit der Anode einer mit ihrer Katode ebenfalls am invertierenden Eingang liegenden Diode D2 verbunden. Die über einen Kondensator C9 an Masse liegende Katode der Diode D2 ist über einen Widerstand R14 mit dem über einen Widerstand R15 an Masse liegenden nicht-invertierenden Eingang des als Torschalter 8 vorgesehenen ersten Operationsverstärkers V1 verbunden.

An den Ausgang des als Verstärker ausgebildeten selektiven Filters 7 ist eine als Spannungsverdopplerschaltung ausgelegte Gleichrichteranordnung, welche aus Dioden D3; D4, Kondensatoren C10, C11 und einem Widerstand R16 besteht angeschlossen. Die Dioden D3, D4 der Gleichrichteranordnung sind derart gepolt, daß eine an ihrem Ausgang entstehende Spannung negativ gerichtet ist. Der Ausgang der Gleichrichteranordnung ist über den Widerstand R16 mit dem über einen Widerstand R17 mit einer positiven Betriebsspannungsquelle $+UB$ verbundenen nicht-invertierenden Eingang des zweiten Operationsverstärkers V2 verbunden.

Wird mit dem vorgenannten Empfänger ein in Folge von Mehrwegeempfang, Abschattung, Seitenbandstörungen durch Nachbarsender, Zündstörung usw. gestörtes Signal empfangen, so treten am Ausgang des FM-Demodulators 4 auch oberhalb des Multiplexsignalbereiches, also oberhalb von 53 kHz, Störimpulse auf. Mit dem einen Verstärker aufweisenden selektiven Filter 7 werden vorzugsweise die Störanteile im Bereich von 150 kHz erkannt und verstärkt. Die Störanteile gelangen nun über den Kondensator C4, den ersten Operationverstärker V1 zur ersten Gleichrichterstufe 9, welche den Ladekondensator C5 auflädt. Die Höhe der Spannung an diesem Kondensator C5 ist bereits ein Maß für die Größe der Störanteile sowie für die Empfangsqualität des empfangenen Signals.

Durch Mehrwegeempfang verursachte Störungen sind völlig unabhängig von der Feldstärke des Empfangssignals und treten nur dann störend auf, wenn eine NF-Modulation des Trägers vorhanden ist. Es ist daher zweckmäßig, bei Modulationspausen keine Messungen vorzunehmen. Hierzu wird ein NF-Frequenzanteil des am Ausgang des FM-Demodulators anstehenden Signals über den NF-Bandpaß 11 und den dritten Operationsverstärker V3 der als Spitzengleichrichter ausgebildeten zweiten Gleichrichterstufe 12 zugeführt Das am Kondensator C9 anstehende Gleichspannungssignal gibt Aufschluß darüber, ob ein NF-Modulationssignal vorliegt oder nicht. Die Rückstellzeitkonstante für einen Ausfall der NF-Modulation wird durch die Dimensionierung der Widerstände R14, R15 und des Kondensators C9 bestimmt. Über den Steuereingang des Transistors T4 kann zu Beginn jeder Messung durch einen Reset-Impuls auf aktuelle NF-Wiedergabe abgefragt werden.

Bei vorhandenem Modulationssignal gelangt von der Diode D2 eine positive Spannung an den nicht-invertierenden Eingang des Operationsverstärkers V1, wodurch dieser die ihm über den Kondensator C4 zugeführten Störsignale verstärkt. Die verstärkten und mittels der Diode D1 gleichgerichteten Störsignale werden dem Ladekondensator C5 zugeführt und nach Frequenz, Häufigkeit und Amplitude integriert. Durch den resultierenden Widerstandswert der parallel wirkenden Widerstände R9, R10 wird die für die Meßzeit ausschlaggebende Integrationsdauer bestimmt. Je häufiger bzw. anhaltender Störsigale auftreten, desto höher ist die Gleichspannung am Kondensator C5. Die Ladespannung von C5 sowie die am einstellbaren Spannungsteiler Rx abgegriffene Gleichspannung werden dem invertierenden Eingang des zweiten Operationsverstärkers V2 zugeführt. Bei einem hohen Störgrad des empfangenen Signals ist der Ladekondensator C5 maximal aufgeladen, über den Spannungsteiler Rx ist eine kleine Gleichspannung zum Störvergleich einzuregeln, um ein Umkippen des Ausgangsstatus vom Operationsverstärker V2 und somit ein Durchschalten des Transistors T3 und ein Aufleuchten der Anzeigelampe La zu erreichen. Bei fehlenden Störungen ist der Ladekondensator C5 ungeladen. Um wiederum eine Anzeige zu erhalten, muß der Spannungsteiler Rx auf eine maximale Gleichspannung geregelt werden. Hierdurch ist es nun möglich, den Grad der Störungen durch eine Auswertung der mit dem Spannungsteiler Rx eingestellten Vergleichsspannung zu bewerten.

Treten nun länger anhaltende, insbesondere durch Nachbarsender, mangelnde Selektion, Zündfunken usw., hervorgerufene Störungen auf, so wird durch ein Trägergleichrichtung mittels der Dioden D3, D4 eine negative Gleichspannung erzeugt, welche im Fußpunkt des aus den Widerständen R16, R17 gebildeten Spannungsteilers eingespeist wird.

Hierdurch verschiebt sich der Arbeitspunkt des zweiten Operationsverstärkers V2 und somit wird eine Addition der unterschiedlichen Störgrößen möglich, welche ebenfalls über die Größe der am Spannungsteiler RX eingestellten Spannung bewertbar ist.

Für die richtige Bewertung der Qualität eines Empfangssignales werden der Pegelvergleichsstufe 10 über die Leitung A von der Steuerschaltung für Sendersuchlauf 2 unterschiedliche Pegelwerte vorgegeben. Das Unter- bzw. Überschreiten eines vorgegebenen Pegels durch einen Pegel des Ist-Wertes wird der Steuerschaltung 2 über die Leitung B mitgeteilt. Somit ist es möglich, nicht nur die Störpegel zweier mit getrennten Empfängerzügen gleichzeitig empfangener Sender miteinander zu vergleichen, sondern auch die Störpegelwerte zuvor empfangener Sender zu speichern und diese als Sollwerte für einen Pegelvergleich beim Empfang eines Senders zu verwenden. Es ist jedoch auch ohne weiteres möglich, lediglich die an den Kondensatoren C5 und/oder C11 auftretenden Spannungen für die Beurteilungen einer Störung zu verwenden.

## Claims

1. FM station-finding receivers equipped for stereo reception in motor vehicles, comprising a control circuit (2) for switching between transmitters having the same programme content, characterized in that a signal path from the output of the FM demodulator (4) to the input of the station-finding circuit in the control circuit (2) comprises a selective band filter (7) having a bandwidth, which is narrow in comparison with the IF bandwidth of the receiver, above the stereo multiplex signal within the IF bandwidth for filtering out, in particular, interference signals caused by multipath reception, a gate switch (8), a rectifier arrangement (D1), an integration stage (C5, R8, R9) and a level comparison stage (10) which compares the output signal of the integration stage, which corresponds to the current interference level, with a level value predetermined by the control circuit (2), and in that the control input of the gate switch (8) is connected via an AF bandpass filter (11) and a rectifier stage (12) to the output of the FM demodulator (4), and that the level comparison stage (10) emits a signal for switching to a different transmitter to the control circuit (2) when a predetermined level value is exceeded by the interference level.

2. FM receivers equipped for stereo reception in motor vehicles, comprising several aerials and a control circuit (2) for switching between the aerials, characterized in that a signal path from the output of the FM demodulator (4) to the input of the change-over switch for the aerial configuration in the control circuit (2) comprises a selective bandpass filter (7) having a bandwidth, which is narrow in comparison with the IF bandwidth of the receiver, above the stereo multiplex signal within the IF bandwidth for filtering out, in particular, interference signals caused by multipath reception, a gate switch (8), a rectifier arrangement (D1), an integration stage (C5, R8, R9) and a level comparison stage (10) which compares the output signal of the integration stage, which corresponds to the current interference level, with a level value predetermined by the control circuit (2), and in that the control input of the gate switch (8) is connected via an AF bandpass filter (11) and a rectifier stage (12) to the output of the FM demodulator (4), and in that the level comparison stage (10) emits a signal for switching to a different aerial to the control circuit (2) when a predetermined level value is exceeded by the interference level.

3. Circuit arrangement according to Claim 1 or 2, characterized in that the centre frequency of the selective bandpass filter (7) is higher than 70 kHz.

4. Circuit arrangement according to Claim 1 or 2, characterized in that the selective bandpass filter (7) is designed for a centre frequency of about 150 kHz and has a bandwidth of about 15 kHz.

5. Circuit arrangement according to Claim 1 or 2, characterized in that the AF bandpass filter (11) has a passband of about 200 Hz to 5,000 Hz.

6. Circuit arrangement according to Claim 1 or 2, characterized in that the selective bandpass filter (7) consists of a selective amplifier.

7. Circuit arrangement according to Claim 1 or 2, characterized in that the signal taken from the AF bandpass filter (11) is supplied to a rectifier stage (12) constructed as peak rectifier, the output signal of which is supplied to an input of a first operational amplifier (V1) provided as gate switch (8).

8. Circuit arrangement according to Claim 7, characterized in that the integration section (C5, R8, R9) is connected to one input of a second operational amplifier (V2) and via a resistor (R10) to an output of an adjustable voltage divider (Rx) connected to an operating voltage source (UB) and in that the operational amplifier (V2) is followed by an indicating device (La), the operating point of which can be determined by means of the adjustable voltage divider (Rx).

**Revendications**

1. Récepteur à recherche à ondes ultracourtes prévu pour la réception stéréophonique dans des véhicules automobiles, comportant un circuit de commande (2) pour commuter entre eux les émetteurs correspondant à la même modulation, circuit caractérisé par un chemin de signal allant de la sortie du démodulateur (MF4) jusqu'à l'entrée du circuit de recherche d'émetteur dans le circuit de commande (2), un filtre basse-bande (7) sélectif avec une largeur de bande faible par comparaison à la largeur de bande (FI) du récepteur, au-delà du signal de multiplexage stéréo à l'intérieur de la largeur de la bande (FI) pour séparer par filtrage notamment les signaux parasites engendrés par la réception selon les chemins multiples, une porte (8), un redresseur (D1), un étage d'intégration (C5, R8, R9) et un comparateur de niveaux (10) qui compare le signal de sortie de l'étage d'intégration correspondant au niveau de parasite réel à un niveau prédéterminé par le circuit de commande (2), et l'entrée de commande de la porte (8) est reliée par un filtre passe-bande (11) BF et un étage redresseur (12) à la sortie du démodulateur (FM4) et en ce que le comparateur de niveau (10) crée un signal de commutation sur un autre émetteur pour le dispositif de commande (2) lorsqu'on dépasse un niveau prédéterminé.

2. Récepteur à ondes ultra-courtes prévu pour la réception stéréo dans des véhicules automobiles, comportant plusieurs antennes et un circuit de commande (2) commutant entre les antennes, caractérisé par un chemin de signal reliant la sortie du démodulateur (MF4) à l'entrée de l'inverseur pour la configuration d'antenne dans le dispositif de cómmande (2), un filtre passe-bande (7) sélectif à largeur de bande faible par comparaison à la largeur de bande (FI) du récepteur, au-delà du signal de multiplexage stéréo à l'intérieur de la largeur de bande (FI) pour séparer par filtrage, notam-

ment les signaux parasites créés par la réception selon des chemins multiples, une porte (8), un redresseur (D1), un étage d'intégration (C5, R8, R9) et un comparateur de niveau (10) qui compare le signal de sortie de l'étage d'intégration correspondant au niveau parasite réel, à un niveau prédéterminé par le circuit de commande (2) et l'entrée de commande de la porte (8) est reliée par un filtre passe-bande (BF 11) et un redresseur (12) à la sortie du démodulateur (MF4) et en ce que l'étage de comparaison de niveau (10), lors du dépassement d'un seuil prédéterminé par le niveau parasite fournit un signal au dispositif de commande (2) pour passer sur une autre antenne.

3. Circuit selon la revendication 1 ou 2, caractérisé en ce que la fréquence intermédiaire du filtre à bande passante (7), sélectif, est supérieure à 70 KHz.

4. Circuit selon la revendication 1 ou 2, caractérisé en ce que le filtre passe-bande (7) sélectif est conçu pour une fréquence intermédiaire d'environ 150 KHz et présente une largeur de bande d'environ 15 KHz.

5. Circuit selon la revendication 1 ou 2, caractérisé en ce que le filtre passe-bande (BF11) présente une plage passante comprise entre environ 200 Hz et 5000 Hz.

6. Circuit selon la revendication 1 ou 2, caractérisé en ce que le filtre passe-bande (7) sélectif est constitué par un amplificateur sélectif.

7. Circuit selon la revendication 1 ou 2, caractérisé en ce que le signal fourni par le filtre passe-bande (BF11) est appliqué à un étage redresseur (12) en forme de redresseur écrêteur dont le signal de sortie est appliqué à une entrée d'un premier amplificateur opérationnel (V1) constituant la porte (8).

8. Circuit selon la revendication 7, caractérisé en ce que l'élément d'intégration (C5, R8, R9) est relié à une entrée d'un second amplificateur opérationnel (V2) et par une résistance (R10) à une sortie d'un diviseur de tension (Rx) réglable relié à une source de tension de fonctionnement (UB) et en ce que l'amplificateur opérationnel (B2) comporte en aval un voyant (LA) dont le point de mise en oeuvre se détermine dans le diviseur de tension (Rx) réglable.

**Ansprüche**

1. Für den Stereoempfang in Kraftfahrzeugen eingerichtete UKW-Suchlaufempfänger mit einer Steuerschaltung (2) zum Umschalten zwischen Sendern gleichen Modulationsinhaltes, dadurch gekennzeichnet, daß ein Signalweg vom Ausgang des FM-Demodulators (4) zum Eingang der Sendersuchlaufschaltung in der Steuerschaltung (2) ein selektives Bandfilter (7) mit einer im Vergleich zur ZF-Bandbreite des Empfängers geringen Bandbreite oberhalb des Stereomultiplexsignals innerhalb der ZF-Bandbreite zur Ausfilterung von insbesondere durch Mehrwegeempfang verursachten Störsignalen, einen Torschalter (8), eine Gleichrichteranordnung (D1), eine Integrationsstufe (C5, R8, R9) und eine Pegelvergleichsstufe (10), welche das Ausgangssignal der Integrationsstufe, das dem aktuellen Störpegel entspricht, mit einem von der Steuerschaltung (2) vorgegebenen Pegelwert vergleicht, umfaßt und daß der Steuereingang des Torschalters (8) über ein NF-Bandpaßfilter (11) und eine Gleichrichterstufe (12) mit dem Ausgang des FM-Demodulators (4) verbunden ist, und daß die Pegelvergleichsstufe (10) beim Überschreiten eines vorgegebenen Pegelwertes durch den Störpegel ein Signal zum Umschalten auf einen anderen Sender an die Steuerschaltung (2) abgibt.

2. Für den Stereoempfang in Kraftfahrzeugen eingerichtete UKW-Empfänger mit mehreren Antennen und einer Steuerschaltung (2) zum Umschalten zwischen den Antennen, dadurch gekennzeichnet, daß ein Signalweg vom Ausgang des FM-Demodulators (4) zum Eingang des Umschalters für die Antennenkonfiguration in der Steuerschaltung (2) ein selektives Bandpaßfilter (7) mit einer im Vergleich zur ZF-Bandbreite des Empfängers geringen Bandbreite oberhalb des Stereomultiplexsignals innerhalb der ZF-Bandbreite zur Ausfilterung von insbesondere durch Mehrwegeempfang verursachten Störsignalen, einen Torschalter (8), eine Gleichrichteranordnung (D1), eine Integrationsstufe (C5, R8, R9) und eine Pegelvergleichsstufe (10), welche das Ausgangssignal der Integrationsstufe, das dem aktuellen Störpegel entspricht, mit einem von der Steuerschaltung (2) vorgegebenen Pegelwert vergleicht, umfaßt und daß der Steuereingang des Torschalters (8) über ein NF-Bandpaßfilter (11) und eine Gleichrichterstufe (12) mit dem Ausgang des FM-Demodulators (4) verbunden ist, und daß die Pegelvergleichsstufe (10) beim Überschreiten eines vorgegebenen Pegelwertes durch den Störpegel ein Signal zum Umschalten auf eine andere Antenne an die Steuerschaltung (2) abgibt.

3. Schaltungsanordnung nach Anspruch 1 oder 2,
   dadurch gekennzeichnet,
   daß die Mittenfrequenz des selektiven Bandpaßfilters (7) größer als 70 kHz ist.

4. Schaltungsanordnung nach Anspruch 1 oder 2,
   dadurch gekennzeichnet,
   daß das selektive Bandpaßfilter (7) für eine
   Mittenfrequenz von etwa 150 kHz ausgelegt ist
   und eine Bandbreite von etwa 15 kHz aufweist.

5. Schaltungsanordnung nach Anspruch 1 oder 2,
   dadurch gekennzeichnet,
   daß das NF-Bandpaßfilter (11) einen Durchlaßbereich von etwa 200 Hz bis 5 000 Hz aufweist.

6. Schaltungsanordnung nach Anspruch 1 oder 2,
   dadurch gekennzeichnet,
   daß das selektive Bandpaßfilter (7) aus einem
   selektiven Verstärker besteht.

7. Schaltungsanordnung nach Anspruch 1 oder 2,
   dadurch gekennzeichnet,
   daß das dem NF-Bandpaßfilter (11) entnommene Signal einer als Spitzengleichrichter ausgebildeten Gleichrichterstufe (12) zugeführt ist,
   deren Ansgangssignal einen Eingang eines als
   Torschalter (8) vorgesehenen ersten Operationsverstärkers (V1) zugeführt ist.

8. Schaltungsanordnung nach Anspruch 7,
   dadurch gekennzeichnet,
   daß das Integrationsglied (C5, R8, R9) mit ei-
   nem Eingang eines zweiten Operationsverstär-
   kers (V2) und über einen Widerstand (R10) mit
   einem Ausgang eines an einer Betriebsspannungsquelle (UB) liegenden einstellbaren
   Spannungsteilers (Rx) verbunden ist und daß
   dem Operationsverstärker (V2) eine Anzeigeeinrichtung (La) nachgeschaltet ist, deren An-
   sprechpunkt mit dem einstellbaren Spannungs-
   teiler (Rx) bestimmbar ist.

Fig. 1

EP 0 069 214 B1

Fig. 2